# EUROPÄISCHE PATENTSCHRIFT

(11) **EP 2 309 035 B1**
(45) Veröffentlichungstag und Bekanntmachung des Hinweises auf die Patenterteilung: **10.12.2014**
(21) Anmeldenummer: 10175990.0
(22) Anmeldetag: 09.09.2010
(51) Int. Cl.: H01L 31/0224, H01L 31/0216, C25D 3/46, C25D 3/02

(54) **Elektrolytzusammensetzung**
Electrolyte composition
Composition d'électrolyte

(30) Priorität: 17.09.2009 DE 102009029558
(43) Veröffentlichungstag der Anmeldung: 13.04.2011
(73) Patentinhaber: Fraunhofer Gesellschaft zur Förderung der angewandten Forschung e.V., 80686 München (DE)
(72) Erfinder: Lippert, Lothar, 65549, Limburg (DE); Dauwe, Dr. Stefan, 63825, Blankenbach (DE)

(56) Entgegenhaltungen:
- EP-A1- 1 674 534
- WO-A1-2009/135505
- WO-A2-2006/136333
- US-A1- 2004 067 866

## Beschreibung

Die vorliegende Anmeldung betrifft eine Elektrolytzusammensetzung zur Abscheidung von Metallen auf Substrate. Die Elektrolytzusammensetzung umfasst wenigstens die Metallionen des Metalls, zu dessen Abscheidung die Zusammensetzung bestimmt ist.

Galvanische Abscheidung von Metallen aus Elektrolytlösungen ist aus dem Stand der Technik bekannt. Zu diesem Zweck ist es erforderlich, das entsprechende Metall in Form seiner Ionen in Lösung zu bringen und zu halten. Hierfür werden für gewöhnlich Komplexbildner eingesetzt. Ein wichtiges Kriterium für geeignete Komplexbildner ist die ausreichend hohe Stabilität des jeweilig gebildeten Komplexes. Als Komplexbildner wird im Stand der Technik vielfach Cyanid verwendet, das mit zahlreichen Metallen sehr stabile Komplexe eingeht. Gerade Silber wird von Cyanid hervorragend komplexiert und liefert gute Ergebnisse bei der Abscheidung des Metalls auf Oberflächen. Cyanid hat jedoch den Nachteil, überaus giftig zu sein, so dass es nicht erwünscht ist, diesen Komplexbildner einzusetzen.

Es wurden daher viele Versuche unternommen, den giftigen Komplexbildner Cyanid durch andere Komplexbildner zu ersetzen. Ein Beispiel eines solchen Komplexbildners ist Hydantoin sowie einige seiner Derivate. Der Einsatz von Hydantoin als Komplexbildner wird beispielsweise in EP 1 918 426 A2 diskutiert.

Ein weiterer organischer Komplexbildner, der aus dem Stand der Technik bekannt ist, ist das Succinimid sowie seine Derivate. Dieser Komplexbildner wird beispielsweise in US 4,126,524 vorgestellt.

Die nach dem Anmeldetag der vorliegenden Anmeldung veröffentlichte WO 2009/135505 beschreibt Mischungen von Palladium mit Nickel, Eisen, Kobalt oder Silber in einer Elektrolytzusammensetzung, die wässrig ist, wobei die abzuscheidenden komplexierten Metallionen in Form ihrer Salze mit Oxidhydroxid, Hydroxid, Hydrogencarbonat und/oder Carbonat als Gegenionen vorliegen und als weiterer Zusatzstoff Iminodisuccinsäure enthalten ist. Dieses Dokument ist die Grundlage für den Disclaimer in Anspruch 1.

Bekannte cyanidfreie Elektrolytzusammensetzungen haben einen entscheidenden Nachteil, nämlich die sehr langsame Abscheidegeschwindigkeit von lediglich 0,8 bis 1 µm pro Minute. Langsame Abscheidegeschwindigkeit führt dazu, dass die Anlage zur elektrolytischen Abscheidung sehr lang ausgestaltet werden muss. Dadurch werden nicht nur die Anschaffungs- und Unterhaltskosten der Anlage stark in die Höhe getrieben, sondern auch die Kosten für die zu verwendende Elektrolytzusammensetzung. Bei den hohen Preisen bestimmter Metalle, wie beispielsweise Silber, wird eine hohe Abscheidegeschwindigkeit somit zunehmend interessant.

Eine geeignete Elektrolytzusammensetzung sollte ferner die Eigenschaft haben, auch fremde Metallionen, die nicht zur Abscheidung auf dem jeweiligen Substrat vorgesehen sind, zu komplexieren und somit die Stabilität der Elektrolytzusammensetzung während des gesamten Abscheidungsprozesses und darüber hinaus zu erhalten. Es ist ferner wünschenswert, dass die Elektrolytzusammensetzung auch pH-Wert-Schwankungen, die während der Galvanisierung auftreten, übersteht. Succinimid- und Hydantoinderivate haben diese Eigenschaften nicht.

Es ist besonders erstrebenswert, Elektrolytzusammensetzungen bereitzustellen, die geeignet sind, Metalle, insbesondere Silber, auf Solarzellen abzuscheiden. Die galvanische Abscheidung von Silber auf Solarzellen ist einerseits besonders erstrebenswert, da die aufgebrachte Schicht eine Leitfähigkeit nahe an der theoretischen Leitfähigkeit aufweist, andererseits jedoch technisch anspruchsvoll. Solarzellen weisen üblicherweise eine Aluminiumrückseite auf. Somit ist ein mild alkalischer pH-Wert außerordentlich wichtig, sonst würde sich das Aluminium lösen, was unerwünscht ist. Ein pH-Wert von idealerweise 9 bis 10 ist während der gesamten Abscheidung einzuhalten, was besondere Elektrolytzusammensetzungen notwendig macht.

Es ist die Aufgabe der Erfindung, eine Elektrolytzusammensetzung bereitzustellen, die eine hohe Abscheidegeschwindigkeit mit hoher Stabilität gegenüber Fremdionen und pH-Schwankungen kombiniert und gleichzeitig nicht toxisch ist. Die Elektrolytzusammensetzung sollte ferner dazu geeignet sein, zur Abscheidung von Metallen, insbesondere Silber, auf Solarzellen verwendet zu werden.

Die Aufgabe wird durch die Gegenstände der Patentansprüche gelöst.

Die Aufgabe wird insbesondere durch eine Elektrolytzusammensetzung zur Abscheidung von Metallen auf ein Substrat, insbesondere eine Solarzelle gelöst, die wenigstens ein Metallion umfasst und durch die Anwesenheit eines Iminodisuccinatderivates als Komplexbildner gekennzeichnet ist, wobei die Metallionen ausgewählt sind aus Ionen des Silbers, Calciums, Magnesiums, Eisens, Chroms, Kobalts, Nickels, Kupfers und Aluminiums mit der Maßgabe, dass es sich bei den Metallionen nicht um Mischungen von Palladium mit Nickel, Eisen, Kobalt oder Silber handelt, wenn die Elektrolytzusammensetzunq wässrig ist, die abzuscheidenden komplexierten Metallionen in Form ihrer Salze mit Oxidhydroxid, Hydroxid, Hydrogencarbonat und/oder Carbonat als Gegenionen vorliegen und das Iminodisuccinatderivat Iminodisuccinsäure ist.

Das Iminodisuccinatderivat der Erfindung wird im Folgenden mit IDSD abgekürzt.

Ein IDSD im Sinne der Erfindung ist gekennzeichnet durch folgende Formel:

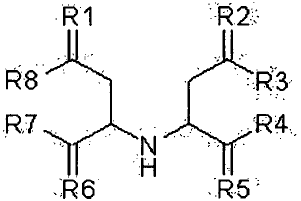

In obiger Formel sind die Reste R1, R2, R5 und R6 ausgewählt aus O, N, H und S; R3, R4, R7 und R8 sind ausgewählt aus OH, NH₂, SH, O⁻ und S⁻, jeweils als Natrium- oder Kaliumsalz.

Das IDSD hat den Vorteil, hervorragende Komplexierungseigenschaften für eine Vielzahl von Metallen zu haben, so dass sich die Zusammensetzung dieser Erfindung gut für die Abscheidung einer großen Bandbreite von Metallen eignet. Gleichzeitig wird die Empfindlichkeit der Elektrolytzusammensetzung vermindert, da auch Verunreinigungen in Form von Fremdionen komplexiert werden können, so dass es nicht zu Ausfällungen aus der Lösung kommt. Ferner ist das IDSD ungiftig und biologisch abbaubar. Das IDSD der vorliegenden Erfindung wird bevorzugt in Form seiner Alkalisalze eingesetzt. Diese sind beispielsweise das Natriumsalz oder Kaliumsalz, wobei das Natriumsalz eine bevorzugte Ausführungsform der Erfindung darstellt. In besonders bevorzugten Ausführungsformen ist das IDSD Iminodisuccinat, insbesondere Tetranatriumiminodisuccinat.

Erfindungsgemäß kann das IDSD in der Elektrolytzusammensetzung in Anteilen von zwischen 50 und 250 g/l eingesetzt werden, sofern das IDSD den Hauptkomplexbildner in der Zusammensetzung darstellt. In bevorzugten Ausführungsformen ist das IDSD der Hauptkomplexbildner und in Anteilen von zwischen 150 und 225 g/l in der Elektrolytzusammensetzung vorhanden.

Hauptkomplexbildner im Sinne der vorliegenden Erfindung bedeutet, dass das Verhältnis des als Hauptkomplexbildner bezeichneten Komplexbildners zu jedem anderen Komplexbildner in der Elektrolytzusammensetzung wenigstens 2:1 beträgt. Bevorzugt beträgt dieses Verhältnis 5:1, weiter bevorzugt 10:1 und am meisten bevorzugt ist der Komplexbildner, der als Hauptkomplexbildner bezeichnet ist, der einzige Komplexbildner in der Elektrolytzusammensetzung.

In alternativen Ausführungsformen wird das IDSD in Kombination mit einem anderen Komplexbildner eingesetzt. In diesen Ausführungsformen wird das IDSD in mengenmäßig kleineren Anteilen eingesetzt als in den Fällen, in denen das IDSD der Hauptkomplexbildner ist. In den Ausführungsformen, in denen IDSD nicht der Hauptkomplexbildner ist, sondern in Kombination mit einem anderen Komplexbildner eingesetzt wird, liegen die Anteile, in denen das IDSD in den Elektrolytzusammensetzungen der Erfindung vorliegt, bei zwischen 2 und 40 g/l. Bevorzugt sind Anteile zwischen 5 und 20 g/l.

Unter Berücksichtigung der oben genannten Mengen, kann das IDSD die Stromausbeute des Abscheidungsvorganges wesentlich erhöhen.

Als möglicher weiterer Komplexbildner, der vorteilhaft in der Elektrolytzusammensetzung eingesetzt werden kann, dient Hydantoin oder eines oder mehrere seiner Derivate. Die Gruppe der Komplexbildner "Hydantoin oder eines oder mehrere seiner Derivate" wird fortan unter dem Oberbegriff Hydantoin zusammengefasst. Bevorzugt wird unter Hydantoin 1-Methylhydantoin, 1,3-Dimethylhydantoin, 5,5-Dimethylhydantoin und 1-Hydroxymethyl-5,5-dimethylhydantoin verstanden. In besonders bevorzugten Ausführungsformen wird neben dem IDSD 5,5-Dimethylhydantoin eingesetzt.

Der weitere Komplexbildner in der Elektrolytzusammensetzung kann in Anteilen von 50 bis 250 g/l in bevorzugten Ausführungsformen eingesetzt werden. Weiter bevorzugt sind Anteile von 100 bis 175 g/l. Wie oben erwähnt kann Hydantoin viele Fremdionen nicht komplexieren. Hierzu zählen beispielsweise Ionen von Nickel, Chrom und Eisen. Wird Hydantoin aber zusammen mit dem IDSD eingesetzt, kann eine sehr unempfindliche Elektrolytlösung hergestellt werden. Eine Kombination von Komplexbildnern hat ferner den Vorteil, dass größere Mengen des Metallions komplexiert werden können. Beispielsweise kann der Komplexbildner IDSD allein lediglich bis zu 20 g/l Silber komplexieren, in Kombination mit 5,5-Dimethylhydantoin sind bis zu 60 g/l möglich.

Die Elektrolytzusammensetzung gemäß der vorliegenden Erfindung ist bevorzugt frei von Sulfonsäurederivaten. Ferner ist die Elektrolytzusammensetzung der vorliegenden Erfindung bevorzugt frei von Cyaniden.

In bevorzugten Ausführungsformen umfasst die Elektrolytzusammensetzung dieser Erfindung einen Leitfähigkeitszusatz. Der Leitfähigkeitszusatz verbessert die Leitfähigkeit der Elektrolytzusammensetzung und senkt dadurch die Zellspannung während der Galvanisierung. Dies ist erwünscht, weil bei besserer Leitfähigkeit der Elektrolytlösung eine verbesserte Stromausbeute erzielt werden kann. Der Leitfähigkeitszusatz ist erfindungsgemäß bevorzugt ein Citrat. Dieses Citrat wird bevorzugt in Anteilen von zwischen 20 und 75 g/l, mehr bevorzugt 30 bis 50 g/l eingesetzt. Citrat übernimmt dabei nicht nur die Funktion eines Leitfähigkeitszusatzes, sondern komplexiert auch Calcium- und Magnesiumionen. Ferner hat der Einsatz des Citrates den Vorteil, dass die Elektrolytlösung unempfindlich gegen den Eintrag von Säuren ist, da Citrat pH-Wert-Schwankungen abpuffern kann. Somit fördert dieser Zusatz die Stabilität der Zusammensetzung. Ein bevorzugt eingesetztes Citrat ist Trikaliumcitrat.

Die Elektrolytzusammensetzung der Erfindung wird bevorzugt auf einen pH-Wert von zwischen 8 und 12, weiter bevorzugt 9,5 bis 11 eingestellt. In diesem pH-Bereich kann IDSD besonders vorteilhaft eingesetzt werden, weil der Protonierungsgrad der komplexierenden Reste ausreichend niedrig ist.

Die Elektrolytzusammensetzung der Erfindung eignet sich zur Abscheidung verschiedenster Metalle auf zahlreiche Substrate. Die Elektrolytzusammensetzung umfasst Metallionen, die ausgewählt sind aus Ionen des Silbers, Kalziums, Magnesiums, Eisens, Chroms, Kobalts, Nickels, Kupfers, Zinns und Aluminiums. In besonders bevorzugten Ausführungsformen umfasst die Elektrolytzusammensetzung Silberionen.

Die Metallionen liegen in der Elektrolytzusammensetzung bevorzugt in Anteilen von 10 bis 60 g/l, bevorzugt 15 bis 40 g/l, vor. Eine besonders bevorzugte Ausführungsform betrifft eine Elektrolytzusammensetzung, in der IDSD der einzige Komplexbildner ist und der Anteil an Metallionen auf höchstens 20 g/l beschränkt ist.

In bevorzugten Ausführungsformen der Erfindung umfasst die Elektrolytzusammensetzung ferner ein Netzmittel. Das Netzmittel erhöht die Benetzbarkeit des Substrates und macht es so der galvanischen Abscheidung leichter zugänglich. Es wurde überraschend gefunden, dass die Zugabe eines Netzmittels die Abscheidung von glänzenden Metallschichten auf dem Substrat ermöglicht. Mit den Verfahren und Elektrolytzusammensetzungen des Standes der Technik können hingegen nur matte Oberflächen erzielt werden. Netzmittel sind oberflächenaktive Substanzen, die einen hydrophilen und einen lipophilen Anteil umfassen. Der hydrophile Anteil umfasst bevorzugt eine Polyalkylenoxidkette, insbesondere eine PEG-Kette. Am meisten bevorzugt ist das Netzmittel Polyethylenglykol-oktyl-(3-sulfopropyl)diether.

Erfindungsgemäß ist ferner die Verwendung der Elektrolytzusammensetzung zur galvanischen Abscheidung von Metallen auf Substraten. Die Substrate sind bevorzugt ausgewählt aus elektrisch leitfähigem Material. Insbesondere sind Substrate bevorzugt, die ausgewählt sind aus Glas, Metallen, Metalllegierungen und Halbleitern. Weiter bevorzugt sind Glas- und Siliciumsubstrate, wobei Silicium das am meisten bevorzugte Substratmaterial ist.

Erfindungsgemäß ist auch ein Verfahren zum Versilbern von Substraten, insbesondere der oben genannten Substrate. Das Verfahren umfasst bevorzugt die Schritte des Einbringens des Substrats in die Elektrolytzusammensetzung dieser Erfindung und des Anlegens einer Spannung zwischen einer Anode und einer Kathode, wobei das Substrat die Kathode darstellt.

Die Stromdichte beträgt bevorzugt etwa 1,5 A/dm².

Durch eine Temperaturerhöhung kann mit einer erhöhten Stromdichte galvanisiert werden. Bevorzugt sind Temperaturen im Bereich zwischen 0 und 100°C, insbesondere zwischen 20 und 70°C.

Um eine homogene Abscheidung zu ermöglichen, wird die Elektrolytzusammensetzung während des Galvanisierungsprozesses bevorzugt gerührt.

Es wurde überraschend gefunden, dass die Elektrolytzusammensetzungen der vorliegenden Erfindung geeignet sind, Metalle auch stromlos abzuscheiden. Es wird in einer besonderen Ausführungsform des erfindungsgemäßen Verfahrens also auf das Anlegen einer Spannung verzichtet. Hierdurch ist es beispielsweise möglich, eine Metallschicht auf ein elektrisch leitfähiges Glas oder ein Messingblech aufzubringen. Die Temperatur muss für ein solches Verfahren bevorzugt wenigstens 40°C betragen.

### Beispiele

Die folgenden konkreten Ausführungsformen der vorliegenden Erfindung schränken ihren Umfang nicht ein, sondern dienen der Illustration.

### Vergleichszusammensetzung 1

Es wurde eine Elektrolytzusammensetzung erprobt, die aus folgenden Komponenten zusammengesetzt war:

| | |
|---|---|
| Silber als Silbermethansulfonat | 30 g/L |
| Trikaliumcitratmonohydrat | 40 g/L |
| Kaliumhydroxid | 65 g/L |
| 5,5-Dimethylhydantoin | 130 g/L |

Der pH-Wert der Zusammensetzung betrug 10,3.

### Beispielzusammensetzung 1

Es wurde eine Elektrolytzusammensetzung erprobt, die aus folgenden Komponenten zusammengesetzt war:

| | |
|---|---|
| Silber als Silbermethansulfonat | 30 g/L |
| Trikaliumcitratmonohydrat | 40 g/L |
| Kaliumhydroxid | 65 g/L |
| 5,5-Dimethylhydantoin | 130 g/L |
| **Tetranatriumiminodisuccinat** | **10 g/L** |

Der pH-Wert der Zusammensetzung betrug 10,3.

### Versuchsdurchführung:

In je einem Becherglas, das mit dem oben genannten Elektrolyten gemäß Beispiel 1 oder Vergleichsbeispiel befüllt war, wurde ein Messingblech mit den

Abmessungen 10 cm x 7 cm für 10 min bei ungepulstem Gleichstrom einseitig galvanisiert. Die Rührerdrehzahl lag bei 400 U/min und die Stromstärke bei 0,75 A. Höhere Stromdichten konnten in diesen Elektrolyten im Becherglas nicht erreicht werden.

Nach dem Galvanisieren wurde auf dem Messingblech, das mit der erfindungsgemäßen Lösung behandelt wurde, eine Gewichtszunahme von 498 mg ermittelt, während die Gewichtszunahme beim der Elektrolytzusammensetzung ohne IDSD nur 333 mg betrug.

In einem weiteren Versuch wurde die Beschichtung von Solarzellen mit den Elektrolytzusammensetzungen des Vergleichsbeispiels und des erfindungsgemäßen Beispiels 2 erprobt. Es wurde bei ansonsten gleicher Durchführung eine Rührerdrehzahl von 210 U/min, eine Stromstärke von 150 mA über einen Zeitraum von 7,5 min angewandt.

### Beispielzusammensetzung 2

| | |
|---|---|
| Silber als Silbermethansulfonat | 30 g/L |
| Trikaliumcitratmonohydrat | 40 g/L |
| Kaliumhydroxid | 65 g/L |
| 5,5-Dimethylhydantoin | 130 g/L |
| **Tetranatriumiminodisuccinat** | **5 g/L** |

Der pH-Wert der Zusammensetzung betrug 10,3.

Die folgenden konkreten Bespiele für eine Silberabscheidung an einer Solarzelle wurden bei gleicher Stromdichte und über einen gleichen Zeitraum durchgeführt. Die Solarzelle hatte eine Größe von 125 x 125 mm mit 6% leitender Fläche.

Mit der erfindungsgemäßen Elektrolytzusammensetzung konnte bei einer Spannung von 0,7 V eine Gewichtszunahme von 353 mg an der Solarzelle festgestellt werden. Die Stromausbeute erreichte 70,5%. Die galvanisierte Schichtdicke am Kontaktfinger betrug 11,9 µm.

Bei der Elektrolytlösung des Vergleichsbeispiels konnte bei einer Spannung von 0,59 V eine Gewichtszunahme von 320 mg an der Solarzelle festgestellt werden. Die Stromausbeute erreichte 63%. Die galvanisierte Schichtdicke am Kontaktfinger betrug 9 µm.

Es ist damit gezeigt, dass durch den Einsatz von IDSD in Elektrolytzusammensetzungen bei sonst gleichen Bedingungen eine Verbesserung des Elektrolytwirkungsgrades erzielt werden kann. Die galvanisierte Schichtdicke korreliert mit der Galvanisierungszeit. Wie gezeigt, konnten für gleiche Bedingungen mit Blick auf die Stromdichte und Zeit erfindungsgemäß eine um mehr als 30% gesteigerte Schichtdicke erreicht werden. Bei angestrebten mittleren Schichtdicken von etwa 7 bis 8 µm lässt sich durch den Einsatz der erfindungsgemäßen Elektrolytzusammensetzung ein erheblicher Zeitvorteil von deutlich über 30% erzielen.

### Beispielzusammensetzung 3

Eine erfindungsgemäße Elektrolytzusammensetzung mit IDSD als einzigem Komplexbildner umfasst die folgenden Komponenten:

| | |
|---|---|
| Tetranatriumiminodisuccinat (Baypure CX100 von Lanxess) | 200 g/l |
| Trikaliumcitratmonohydrat | 40 g/l |
| Kaliumhydroxid | 65 g/l |
| Silber als Silbermethansulfonat | 18 g/l |
| ionogenes Netzmittel EA 15-90 Raschig | 7 ml/l |
| Methansulfonsäure (pH-Einstellung auf pH = 10,0) | 10 ml/l |

### Beispielzusammensetzung 4

Eine erfindungsgemäße Elektrolytzusammensetzung mit IDSD als einzigem Komplexbildner umfasst die folgenden Komponenten:

| | |
|---|---|
| Tetranatriumiminodisuccinat (Baypure CX100 von Lanxess) | 200 g/l |
| Natriummethansulfonat | 40 g/l |
| Kaliumhydroxid | 65 g/l |
| Silber als Silbermethansulfonat | 18 g/l |
| ionogenes Netzmittel EA 15-90 Raschig | 7 ml/l |
| Methansulfonsäure (pH-Einstellung auf pH = 10,0) | 10 ml/l |

### Versuch zur Leitfähigkeitsverbesserung mit Citrat

### Vergleichszusammensetzung 2

| | |
|---|---|
| Silber als Silbermethansulfonat | 30 g/L |
| Trikatiumcitratmonohydrat | 0 g/L |
| Kaliumhydroxid | 65 g/L |
| 5,5-Dimethylhydantoin | 130 g/L |

Der pH-Wert der Zusammensetzung betrug 10,3.

### Beispielzusammensetzung 5

| | |
|---|---|
| Silber als Silbermethansulfonat | 30 g/L |
| Trikaliumcitratmonohydrat | 20 g/L |
| Kaliumhydroxid | 65 g/L |
| 5,5-Dimethylhydantoin | 130 g/L |

Der pH-Wert der Zusammensetzung betrug 10,3.

### Ergebnis:

Bei einer Prozesstemperatur von 40°C, einer Rührerdrehzahl von 130 U/min und einer Stromstärke von 0,75 A konnte mit der Citrat-haltigen Lösung eine Silbermenge von 347 mg auf dem Messingblech abgeschieden werden, während die Citrat-freie Lösung nur zu einer Abscheidung von 154 mg führte. Die Spannung von 2,4 V bzw. 4 V ist ein Maß für die Leitfähigkeit der Zusammensetzung.

## Patentansprüche

1. Elektrolytzusammensetzung zur Abscheidung von Metallen auf ein Substrat, umfassend die folgenden Komponenten
a. Metallionen,
b. ein Iminodisuccinatderivat,
wobei die Metallionen ausgewählt sind aus Ionen des Silbers, Calciums, Magnesiums, Eisens, Chroms, Kobalts, Nickels, Kupfers und Aluminiums
mit der Maßgabe, dass es sich bei den Metallionen nicht um Mischungen von Palladium mit Nickel, Eisen, Kobalt oder Silber handelt, wenn die Elektrolytzusammensetzung wässrig ist, die abzuscheidenden komplexierten Metallionen in Form ihrer Salze mit Oxidhydroxid, Hydroxid, Hydrogencarbonat und/oder Carbonat als Gegenionen vorliegen und das IminodisuccinatderivatIminodisuccinsäure ist.

2. Elektrolytzusammensetzung nach Anspruch 1, wobei das Iminodisuccinatderivat ausgewählt ist aus Strukturen der allgemeinen Formel 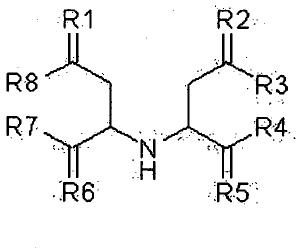 wobei
R1, R2, R5 und R6 ausgewählt sind aus O, N und S und
R3, R4, R7 und R8 ausgewählt sind aus OH, NH₂, SH, O⁻ und S⁻.

3. Die Elektrolytzusammensetzung nach Anspruch 1 oder 2, wobei das Iminodisuccinatderivat als Salz vorliegt.

4. Die Elektrolytzusammensetzung nach Anspruch 3, wobei es sich um das Natrium- oder Kaliumsalz handelt.

5. Elektrolytzusammensetzung nach einem oder mehreren der vorhergehenden Ansprüche, wobei die Metallionen ausgewählt sind aus Ionen des Silbers.

6. Elektrolytzusammensetzung nach einem oder mehreren der vorhergehenden Ansprüche, wobei die Metallionen in Konzentrationen von 10 bis 60 g/L aufweist.

7. Elektrolytzusammensetzung nach einem oder mehreren der vorhergehenden Ansprüche, wobei das Iminodisuccinatderivat ausgewählt ist aus Alkalisalzen des Iminodisuccinats.

8. Elektrolytzusammensetzung nach einem oder mehreren der vorhergehenden Ansprüche, wobei das Iminodisuccinatderivat der Hauptkomplexbildner in der Zusammensetzung ist und in Anteilen von zwischen 50 und 250 g/L, bevorzugt zwischen 150 und 225 g/L eingesetzt wird.

9. Elektrolytzusammensetzung nach einem oder mehreren der vorhergehenden Ansprüche, wobei das Iminodisuccinatderivat in Kombination mit einem anderen Komplexbildner eingesetzt und in Anteilen von zwischen 2 und 40 g/L, bevorzugt zwischen 5 und 20 g/L, zugesetzt wird.

10. Elektrolytzusammensetzung nach einem oder mehreren der vorhergehenden Ansprüche, wobei diese zusätzlich ein Hydantoin aufweist, bevorzugt in Anteilen von 50 bis 250 g/L, mehr bevorzugt 100 bis 175 g/L.

11. Elektrolytzusammensetzung nach einem oder mehreren der vorhergehenden Ansprüche, wobei diese zusätzlich ein 5,5-Dimethylhydantoin aufweist.

12. Elektrolytzusammensetzung nach einem oder mehreren der vorhergehenden Ansprüche, wobei diese frei von Cyaniden ist.

13. Elektrolytzusammensetzung nach einem oder mehreren der vorhergehenden Ansprüche, wobei diese ferner ein Citrat aufweist, bevorzugt in einem Anteil von 20 bis 75 g/L, mehr bevorzugt 30 bis 50 g/L.

14. Elektrolytzusammensetzung nach einem oder mehreren der vorhergehenden Ansprüche, wobei diese einen pH-Wert von zwischen 8 und 12, bevorzugt 9,5 bis 11 aufweist.

15. Verwendung einer Elektrolytzusammensetzung zur galvanischen Abscheidung von Metallen auf ein Substrat, umfassend die folgenden Komponenten
a. Metallionen.
b. ein Iminodisuccinatderivat,
mit der Maßgabe, dass es sich bei den Metallionen nicht um Mischungen von Palladium mit Nickel, Eisen, Kobalt oder Silber handelt, wenn die Elektrolytzusammensetzung wässrig ist, die abzuscheidenden komplexierten Metallionen in Form ihrer Salze mit Oxidhydroxid, Hydroxid, Hydrogencarbonat und/oder Carbonat als Gegenionen vorliegen und das Iminodisuccinatderivat Iminodisuccinsäure ist.

16. Verwendung gemäß Anspruch 15, wobei es sich bei den Substraten um Solarzellen handelt.

17. Verfahren zum Versilbern von Substraten umfassend die Schritte:
c. Einbringen eines Substrats in eine Elektrolytzusammensetzung gemäß einem der Ansprüche 1 bis 14 und
d. Anlegen einer Spannung zwischen einer Anode und einer Kathode, wobei das Substrat die Kathode darstellt.

## Claims

1. An electrolyte composition for the deposition of metals onto a substrate, comprising the following components
a. metal ions,
b. an iminodisuccinate derivative,
wherein the metal ions are selected from ions of silver, calcium, magnesium, iron, chromium, cobalt, nickel, copper and aluminum,
with the proviso that the metal ions are not mixtures of palladium with nickel, iron, cobalt or silver, when the electrolyte composition is an aqueous one, the complexed metal ions to be deposited are present in the form of their salts with oxide-hydroxide, hydroxide, hydrogen carbonate and/or carbonate as counterions and the iminodisuccinate derivative is iminodisuccinic acid.

2. The electrolyte composition according to claim 1, wherein the iminodisuccinate derivative is selected from structures of the general formula 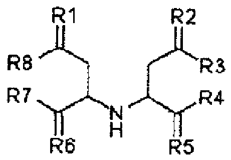 wherein
R1, R2, R5 and R6 arc selected from O, N and S, and
R3, R4, R7 and R8 are selected from OH, NH₂, SH, O⁻ and S⁻.

3. The electrolyte composition according to claim 1 or 2, wherein the iminodisuccinate derivative is present as a salt.

4. The electrolyte composition according to claim 3, wherein it is the sodium or potassium salt.

5. The electrolyte composition according to one or more of the preceding claims, wherein the metal ions are selected from ions of silver.

6. The electrolyte composition according to one or more of the preceding claims, wherein the metal ions are present in concentrations of 10 to 60 g/L.

7. The electrolyte composition according to one or more of the preceding claims, wherein the iminodisuccinate derivative is selected from alkali salts of the iminodisuccinate.

8. The electrolyte composition according to one or more of the preceding claims, wherein the iminodisuccinate derivative is the main complexing agent in the composition and is used in proportions of between 50 and 250 g/L, preferably between 150 and 225 g/L.

9. The electrolyte composition according to one or more of the preceding claims, wherein the iminodisuccinate derivative is used in combination with another complexing agent and is added in proportions of between 2 and 40 g/L, preferably between 5 and 20 g/L.

10. The electrolyte composition according to one or more of the preceding claims, wherein it in addition comprises a hydantoin, preferably in proportions of 50 to 250 g/L, more preferably 100 to 175 g/L.

11. The electrolyte composition according to one or more of the preceding claims, wherein it in addition comprises a 5,5-dimethylhydantoin.

12. The electrolyte composition according to one or more of the preceding claims, wherein it is free of cyanides.

13. The electrolyte composition according to one or more of the preceding claims, wherein it in addition comprises a citrate, preferably in a proportion of 20 to 75 g/L, more preferably 30 to 50 g/L.

14. The electrolyte composition according to one or more of the preceding claims, wherein it has a pH value of between 8 and 12, preferably 9.5 to 11.

15. A use of an electrolyte composition for the galvanic deposition of metals onto a substrate, comprising the following components
a. metal ions,
b. an iminodisuccinate derivative,
with the proviso that the metal ions are not mixtures of palladium with nickel, iron, cobalt or silver, when the electrolyte composition is an aqueous one, the complexed metal ions to be deposited are present in the form of their salts with oxide-hydroxide, hydroxide, hydrogen carbonate and/or carbonate as counterions and the iminodisuccinate derivative is iminodisuccinic acid.

16. The use according to claim 15, wherein the substrates are solar cells.

17. A method for the silver coating of substrates, comprising the steps of:
c. placing a substrate in an electrolyte composition according to one of claims 1 to 14, and
d. applying a voltage between an anode and a cathode, wherein the substrate is the cathode.

## Revendications

1. Composition électrolytique servant à déposer des métaux sur un substrat, comprenant les composants qui suivent :
a. des ions métalliques ;
b. un dérivé d'iminodisuccinate,
sachant que les ions métalliques sont choisis parmi les ions d'argent, de calcium, de magnésium, de fer, de chrome, de cobalt, de nickel, de cuivre et d'aluminium,
à la condition que les ions métalliques ne soient pas des mélanges de palladium avec du nickel, du fer, du cobalt ou de l'argent lorsque la composition électrolytique est soluble dans l'eau, que les ions métalliques complexés à déposer sont présents sous la forme de leurs sels avec, en tant qu'ions complémentaires, de l'hydroxyde d'oxyde, de l'hydroxyde, du carbonate d'hydrogène et/ou du carbonate et que le dérivé d'iminodisuccinate est un acide iminodisuccinique.

2. Composition électrolytique selon la revendication 1, sachant que le dérivé d'iminodisuccinate est choisi parmi des structures de la formule générale : 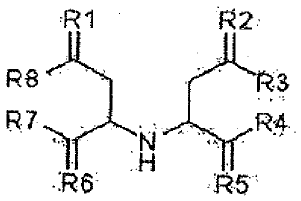 sachant que :
R1, R2, R5 et R6 sont choisis parmi le O, le N et le S ; et
R3, R4, R7, et R8 sont choisis parmi l'CH, le NH₂, le SH, le O⁻ et le S⁻.

3. Composition électrolytique selon la revendication 1 ou 2, sachant que le dérivé d'iminodisuccinate est présent sous la forme de sel.

4. Composition électrolytique selon la revendication 3, sachant qu'il s'agit du sel de sodium ou du sel de potassium.

5. Composition électrolytique selon l'une quelconque ou plusieurs des revendications précédentes, sachant que les ions métalliques sont choisis parmi des ions d'argent.

6. Composition électrolytique selon l'une quelconque ou plusieurs des revendications précédentes, sachant que les ions métalliques présentent des concentrations allant de 10 à 60 g/l.

7. Composition électrolytique selon l'une quelconque ou plusieurs des revendications précédentes, sachant que le dérivé d'iminodisuccinate est choisi par les sels alcalins de l'imminodisuccinate.

8. Composition électrolytique selon l'une quelconque ou plusieurs des revendications précédentes, sachant que le dérivé d'iminodisuccinate est dans la présente composition un agent complexant principal et est utilisé dans des fractions comprises entre 50 et 250 g/l, de préférence comprises entre 150 et 225 g/l.

9. Composition électrolytique selon l'une quelconque ou plusieurs des revendications précédentes, sachant que le dérivé d'iminodisuccinate est utilisé en combinaison avec un autre agent complexant et est ajouté en des fractions comprises entre 2 et 40 g/l, de préférence comprises entre 5 et 20 g/l.

10. Composition électrolytique selon l'une quelconque ou plusieurs des revendications précédentes, sachant que ladite composition électrolytique présente en supplément une hydantoïne, de préférence en des fractions allant de 50 à 250 g/l, de manière davantage préférée en des fractions allant de 100 à 175 g/l.

11. Composition électrolytique selon l'une quelconque ou plusieurs des revendications précédentes, sachant que ladite composition électrolytique présente en supplément un 5,5-diméthylhydantoine.

12. Composition électrolytique selon l'une quelconque ou plusieurs des revendications précédentes, sachant que ladite composition électrolytique ne contient pas de cyanures.

13. Composition électrolytique selon l'une quelconque ou plusieurs des revendications précédentes, sachant que ladite composition électrolytique présente en outre un citrate, de préférence en une fraction allant de 20 à 75 g/l, de manière davantage préférée en une fraction allant de 30 à 50 g/l.

14. Composition électrolytique selon l'une quelconque ou plusieurs des revendications précédentes, sachant que ladite composition électrolytique présente une valeur pH comprise entre 8 et 12, de préférence entre 9,5 et 11.

15. Utilisation d'une composition électrolytique pour déposer par voie galvanique des métaux sur un substrat, ladite composition électrolytique comprenant les composants qui suivent :
a. des ions métallique;
b. un dérivé d'iminodisuccinate,
à la condition que les ions métalliques ne soient pas des mélanges de palladium avec du nickel, du fer, du cobalt ou de l'argent lorsque la composition électrolytique est soluble dans l'eau, que les ions métalliques complexés à déposer sont présents sous la forme de leurs sels avec, en tant qu'ions complémentaires, de l'hydroxyde d'oxyde, de l'hydroxyde, du carbonate d'hydrogène et/ou du carbonate et que le dérivé d'iminodisuccinate est un acide iminodisuccinique.

16. Utilisation selon la revendication 15, sachant que les substrats sont des cellules solaires.

17. Procédé servant à l'argenture de substrats, comprenant les étapes suivantes consistant à :
c. introduire un substrat dans une composition électrolytique selon l'une quelconque des revendications 1 à 4 ; et
d. appliquer une tension entre une anode et une cathode, sachant que le substrat constitue la cathode.
